# EUROPEAN PATENT APPLICATION

(11) **EP 2 744 305 A1**
(43) Date of publication of application: **18.06.2014**
(21) Application number: 12823700.5
(22) Date of filing: 02.08.2012
(51) Int. Cl.: H05B 33/10, C23C 14/00, C23C 14/04, H01L 51/50

(54) **METHOD AND DEVICE FOR MANUFACTURING ORGANIC EL ELEMENT**

(30) Priority: 12.08.2011 JP 2011177030
(71) Applicant: Nitto Denko Corporation, Osaka 567-8680 (JP)
(72) Inventor: NEGISHI, Nobukazu, Osaka 567-8680 (JP); MORITA, Shigenori, Osaka 567-8680 (JP); NAGASE, Junichi, Osaka 567-8680 (JP); NAKAI, Takahiro, Osaka 567-8680 (JP); KAKIUCHI, Ryohei, Osaka 567-8680 (JP); HOSOKAWA, Kazuhito, Osaka 567-8680 (JP)
(74) Representative: Stolmár & Partner
(86) International application number: PCT/JP2012/069732
(87) International publication number: WO 2013/024707

(57) **Abstract**

To provide a manufacturing method of an organic EL device, including: arranging a shadow mask, which has a rotating body having a plate shape rotationally driven around a rotary shaft and has an opening formed in the rotating body, in the vicinity of a substrate in contact with a conveyance section, and between the substrate and a nozzle of an evaporation source arranged opposite to the conveyance section and at a close position to the substrate; and while the shadow mask is being rotated so as to follow the movement of the substrate, discharging a vaporized constituent layer forming material of an organic EL film from the nozzle to form a constituent layer of the organic EL film on the other surface side of the substrate to the conveyance section.

## Description

### FIELD OF THE INVENTION

The present invention relates to a method and apparatus for manufacturing an organic EL device that includes an organic EL film having an electrode film and an organic layer formed on a substrate, and that is configured to emit light from the organic layer.

### RELATED ART

Recently, attention has been given to organic EL (electroluminescence) devices, as devices for use as next-generation light emitting displays with low power consumption. An organic EL device is basically composed of an organic layer having a light emitting layer made of an organic light emitting material, and a pair of electrodes. The organic EL devices can emit multicolor light derived from the organic light emitting material. Further, the organic EL device is a self-luminous device. Therefore, attention has been focused thereon for use as a display such as television (TV).

The organic EL device includes a substrate and an organic EL film which is formed over the substrate and in which an organic layer including a light emitting layer is sandwiched between two electrode layers respectively having electrodes opposite to each other (sandwich structure). The organic layer sandwiched between the electrode layers is configured to be supported over the substrate. The organic EL device is formed by stacking an anode layer, an organic layer, and a cathode layer, in this order over the substrate as constituent layers of the organic EL film.

In methods for manufacturing such an organic EL device, vacuum deposition and coating are commonly known as a technique for forming constituent layers of the organic EL film over the substrate. Among these, vacuum deposition is mainly used, particularly because of the capability of increasing the purity of the organic layer forming material and the ease of achieving long life span.

In the above-mentioned vacuum deposition, each constituent layer of the organic EL film is formed by performing deposition using an evaporation source provided in a vacuum chamber of a deposition apparatus at a position facing the substrate. Specifically, a material for forming the constituent layer of the organic EL film is heated by a heating unit provided in the evaporation source so as to be vaporized. The vaporized material for forming the constituent layer (vaporized material) is discharged from the evaporation source so as to be deposited over the substrate to form the constituent layer of the organic EL film.

In such vacuum deposition, a so-called batch process or a so-called roll process is adopted. The batch process is a process in which the constituent layers of the organic EL film are deposited over each piece of the substrate. On the other hand, the roll process is a process in which: a substrate having a strip shape wound in a roll is continuously unwound; while the unwound substrate is supported, for example, by the surface of a rotationally driven can roll, so as to be moved along with the rotation of the can roll, the constituent layers of the organic EL film are continuously deposited over the substrate, and the substrate on which the constituent layers of the organic EL film have been deposited is wound in a roll. Among these, from the viewpoint of cost reduction, it is preferred to manufacture the organic EL device by using the roll process.

In the case where the organic EL device is manufactured by using the roll process in the vacuum deposition in this way, when the constituent layers of the organic EL film are deposited over the substrate, a so-called shadow mask is used for forming the constituent layers of the organic EL film which have desired patterns. Specifically, while a shadow mask having a strip shape and having a plurality of openings in the longitudinal direction thereof and wound into a roll is continuously unwound, the unwound shadow mask is arranged between the evaporation source and the substrate and moved so as to follow the movement of the substrate, and the shadow mask, which has been moved in this way, is wound into a roll to form the constituent layers of the organic EL film, which have the desired patterns, over the substrate moved as described above.

Further, in order to maintain a constant distance between the shadow mask and the substrate, and to keep the shadow mask constantly following the substrate, the shadow mask having a strip shape as described above is hung under predetermined tension over a plurality of rollers arranged between the positions at which the shadow mask is unwound and wound. Thereby, when slippage occurs between the shadow mask and the roller, or when the roller becomes eccentric, the distance between the shadow mask and the substrate is changed, and a large shift or delay is caused between the movement of the substrate and the movement of the shadow mask following the movement of the substrate. This results in a possibility that an organic EL device of which quality is lower than a desired quality is formed because the constituent layer of the organic EL film is deposited at a position shifted from the desired position, and because the organic EL film is deposited in a state of protruding from the outer edge of the desired pattern.

In addition, an organic EL device of much lower quality may be formed if the slippage simultaneously occurs between the shadow mask and each of a plurality of the rollers, or if a plurality of the rollers simultaneously become eccentric.

On the other hand, in the vacuum deposition, a technique is proposed in which the distance between the evaporation source and the substrate is reduced in order to reduce the amount of water taken into the light emitting layer for a longer service life (see Patent Literature 1). However, in the proximity deposition in which deposition is performed by arranging the evaporation source in the vicinity of the substrate, the state of the formed constituent layer of the organic EL film is greatly affected by a slight change in the distance between the shadow mask and the substrate, and by a slight deviation between the movement of the substrate and the movement of the shadow mask following the movement of the substrate. Therefore, an organic EL device of which quality is lower than the desired quality may be more easily formed.

To cope with this problem, a technique is proposed, in which, instead of using a strip-shaped shadow mask, a shutter mechanism is arranged between the evaporation source and the substrate, and in which a film formation pattern is formed over the substrate by opening and closing the shutter (see Patent Literature 2).

### CITATION LIST

### Patent Literature

Patent Literature 1: JP 2003-173870 A
Patent Literature 2: JP Patent No. 4336869

### DISCLOSURE OF THE INVENTION

### PROBLEMS TO BE SOLVED BY THE INVENTION

However, in the technique disclosed in Patent Literature 2, the shutter is disposed at a position relatively far from the substrate, and hence there is a possibility that, after a vaporized material discharged from the evaporation source is controlled to a predetermined pattern by the shutter, the vaporized material spreads outside the predetermined pattern until the vaporized material reaches the substrate, as a result of which the end portions of the constituent layer of the organic EL film protrude from the desired pattern. Further, there is also a possibility that, when the end portions of the constituent layer of the organic EL film spread too much, the formed patterns adjacent to each other are connected to each other.

In view of the above described problems, it is an object of the present invention to provide a method and apparatus for manufacturing an organic EL device which make it possible to manufacture organic EL devices having a relatively excellent quality.

### MEANS FOR SOLVING PROBLEMS

A manufacturing method of an organic EL device, according to the present invention, includes:
feeding a substrate having a strip shape to a conveyance unit;
conveying the substrate while one surface side of the substrate is in contact with a surface of the conveyance unit;
arranging a shadow mask, which has a rotating body having a plate shape rotationally driven around a rotary shaft and has an opening formed in the rotating body, in the vicinity of the substrate in contact with the conveyance unit, and between the substrate and a nozzle of an evaporation source arranged opposite to the conveyance unit and at a close position to the substrate;
while the shadow mask is being rotated so as to follow a movement of the substrate, discharging a vaporized constituent layer forming material of an organic EL film from the nozzle to feed the vaporized constituent layer forming material to the substrate side through the opening to form a constituent layer of the organic EL film on the other surface side of the substrate to the conveyance unit.

Here, "the close position" means a position at which the distance between the nozzle and the substrate is not more than 15 mm, and "the vicinity of the substrate" means that the distance between the shadow mask and the substrate is not more than 1 mm.

Further, in the manufacturing method of the organic EL device according to the present invention, it is preferable that the constituent layer of the organic EL film be composed of one or more of an organic layer including a light emitting layer, an anode layer, and a cathode layer.

Further, in the manufacturing method of the organic EL device according to the present invention, it is possible that the constituent layer of the organic EL film is the cathode layer, and the substrate is formed of a metal material.

Further, in the manufacturing method of the organic EL device according to the present invention, it is preferable that the conveyance unit be a can roll rotationally driven around a rotary shaft.

Further, in the manufacturing method of the organic EL device according to the present invention, it is preferable that the shadow mask be configured to be rotated around the rotary shaft perpendicular to the rotary shaft of the conveyance unit.

Further, it is preferable that the manufacturing method of the organic EL device according to the present invention further include removing the constituent layer forming material of the organic EL film attached to the shadow mask, while forming the constituent layer of the organic EL film over the substrate.

Further, in the manufacturing method of the organic EL device according to the present invention, it is preferable that the constituent layer forming material of the organic EL film, the constituent layer forming material being attached to the shadow mask, be removed by dry etching or heating.

Further, in the manufacturing method of the organic EL device according to the present invention, it is preferable that the opening be formed in an arc shape centering on the rotary shaft of the shadow mask, and a plurality of the openings be arranged along a virtual concentric circle centering on the rotary shaft of the shadow mask.

Further, in the manufacturing method of the organic EL device according to the present invention, it is preferable that, when viewed along the direction perpendicular to the shadow mask, the opening of the nozzle be arranged along the radial direction of the virtual concentric circle, and that r, θ and W satisfy the expression: W = 2 × r × sin (θ / 2), where the distance between the center of the rotary shaft and each of contact points, at which two virtual tangent lines passing through the center of the rotary shaft are in contact with the opening of the nozzle, is r (mm), the angle formed by the two virtual tangent lines is θ (°), and the opening length of the nozzle in the conveying direction of the substrate is W (mm).

Further, in the manufacturing method of the organic EL device according to the present invention, it is preferable that the opening length W of the nozzle in the conveying direction of the substrate be not less than 0.5 mm but not more than 0.174·r mm, where the angle θ ≤ 10°.

A manufacturing apparatus of an organic EL device, according to the present invention, includes:
a substrate feeding section configured to feed a substrate having a strip shape;
a conveyance section configured to convey the substrate while one surface side of the substrate is in contact with a surface of the conveyance section;
an evaporation source provided with a nozzle arranged opposite to the conveyance section and close to the substrate, the evaporation source being configured to discharge a vaporized constituent layer forming material of an organic EL film from the nozzle so as to form a constituent layer of the organic EL film on the other surface side of the substrate to the conveyance section; and
a shadow mask having a rotating body having a plate shape rotationally driven around a rotary shaft and having an opening formed in the rotating body, the shadow mask being arranged in the vicinity of the substrate in contact with the conveyance section, and between the nozzle and the substrate,
wherein the shadow mask is rotated so as to follow the movement of the substrate and thereby the vaporized constituent layer forming material is fed to the substrate side through the opening.

### BRIEF DESCRIPTION OF THE DRAWINGS

FIG.1 is a schematic side sectional view schematically showing an apparatus for manufacturing an organic EL device according to an embodiment of the present invention.
FIG.2 is a schematic top view schematically showing an arrangement relationship between a substrate, a nozzle, and a shadow mask of the present embodiment.
FIG.3 is a schematic side view schematically showing the arrangement relationship between the substrate, the nozzle, and the shadow mask of the present embodiment.
FIG.4 is a schematic top view schematically showing a relationship between the opening length of the nozzle and the size of the shadow mask when seen along the direction perpendicular to the shadow mask.
FIG.5 is a schematic side sectional view schematically showing a removing unit and the periphery of the removing unit.
FIG.6 is a schematic top view schematically showing a first alignment mark, a second alignment mark, a first detection unit, a second detection unit, and the periphery of these.
FIG.7 is a schematic side sectional view schematically showing a state in which a plurality of evaporation sources for forming organic layers are provided in a vacuum chamber.
FIG.8 is a schematic top view schematically showing organic EL films formed over the substrate.
FIG.9A is a schematic side sectional view schematically showing a layer structure of an organic EL device and showing a configuration where the organic EL device includes one organic layer.
FIG.9B is a schematic side sectional view schematically showing a layer structure of an organic EL device and showing a configuration where the organic EL device includes three organic layers.
FIG.9C is a schematic side sectional view schematically showing a layer structure of an organic EL device and showing a configuration where the organic EL device includes five organic layers.
FIG.10 is a schematic sectional view schematically showing a layer structure of an organic EL device formed as a comparative example.
FIG.11 is a schematic side sectional view schematically showing a manufacturing apparatus of an organic EL device, the apparatus being provided with a strip-shaped shadow mask used in the comparative example.

### DESCRIPTION OF EMBODIMENTS

In the following, a method and apparatus for manufacturing an organic EL device, according to the present invention, is described with reference to the drawings.

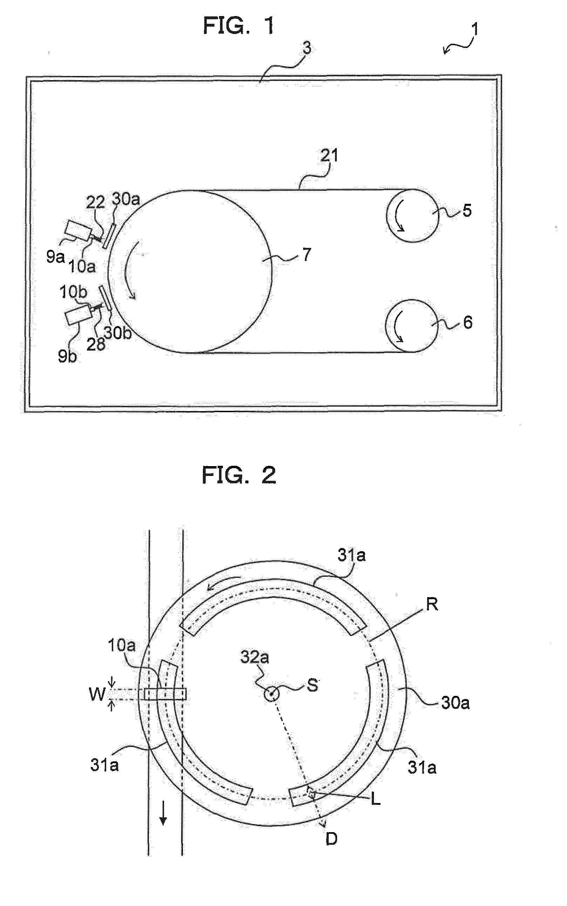

As shown in FIG.1, a manufacturing apparatus 1 of an organic EL device includes: a substrate feeding unit 5 serving as a substrate feeding section for feeding a strip-shaped substrate 21; a can roll 7 serving as a conveyance section for conveying the substrate 21 while the surface of the can roll 7 is brought into contact with one surface side of the substrate 21 fed from the substrate feeding unit 5; a first evaporation source 9a and a second evaporation source 9b serving as a plurality of evaporation sources for respectively discharging vaporized constituent layer forming materials of an organic EL film 19 so as to form constituent layers of the organic EL film 19 on the other surface side of the substrate to the can roll 7, the first and second evaporation sources 9a and 9b respectively having nozzles 10a and 10b respectively arranged at positions facing the can roll 7 and close to the substrate 21; and shadow masks 30a and 30b serving as a plurality of shadow masks. Further, the shadow masks 30a and 30b are provided so as to respectively correspond to the first and second evaporation sources 9a and 9b, and are respectively provided with rotating bodies each having a plate shape which are rotationally driven respectively around rotary shafts 32a and 32b, and in which a plurality of openings 31a and 31b serving as a plurality of openings are formed, respectively. Each of the shadow masks 30a and 30b is provided between the substrate 21 in contact with the can roll 7 and each of the nozzles 10a and 10b so as to be close to the substrate 21.

Further, the manufacturing apparatus 1 includes a vacuum chamber 3 in which the substrate feeding unit 5, the can roll 7, the first and second evaporation sources 9a and 9b, a substrate take-up unit 6 serving as a substrate take-up section, and the shadow masks 30a and 30b are arranged. The inside of the vacuum chamber 3 is brought into a reduced pressure state by a vacuum generating mechanism (not shown), so that a vacuum region should be formed thereinside.

The substrate feeding unit 5 unwinds the substrate 21 having a strip shape wound in a roll, and to feeds it to the can roll 7. Further, the substrate 21 unwound from the substrate feeding unit 5 is fed to the can roll 7 and is then wound up by the substrate take-up unit 6. That is, it is configures such that the substrate 21 is unwound and wound up repeatedly.

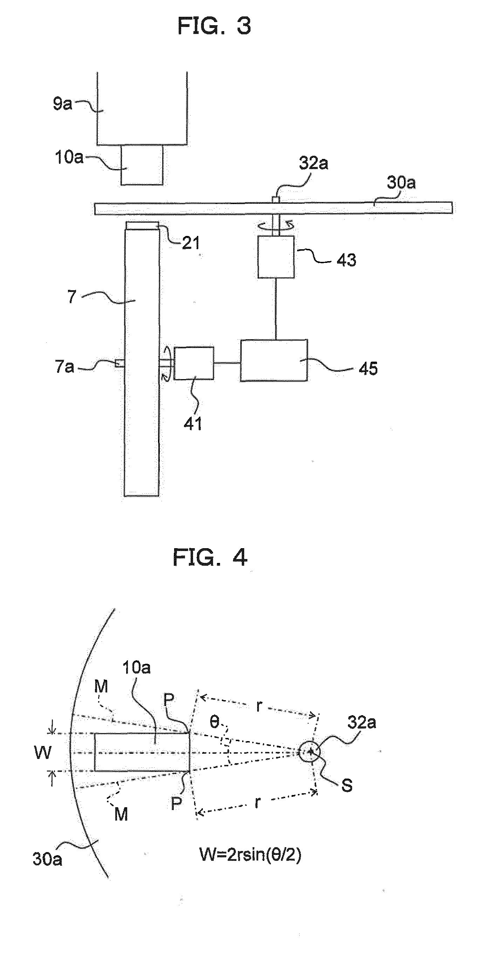

The can roll 7 is formed of stainless steel and is configured to be rotationally driven around a rotary shaft 7a and to convey the substrate 21 while one surface side of the substrate 21 is in contact with the surface of the can roll 7. As shown in FIG.3, the rotary shaft 7a of the can roll 7 is mechanically connected to a first drive unit 41 provided with a motor, and the like, so that the rotational drive force generated by the first drive unit 41 is transmitted to the rotary shaft 7a to rotate the can roll 7 as described above. Further, the first drive unit 41 is electrically connected to a control unit 45 described below, and the rotation speed of the rotary shaft 7a is adjusted by the control unit 45 via the first drive unit 41 so that the moving speed of the substrate 21 is adjusted.

It is preferable that the can roll 7 incorporate therein a temperature control mechanism, such as a cooling mechanism. Thereby, when an organic layer is formed over the substrate 21 as will be described below, the temperature of the substrate 21 can be stabilized. The outer diameter of the can roll 7 can be, for example, 300 to 2000 mm.

As a material for forming the substrate 21, materials having flexibility that is not damaged when being wound around the can roll 7. Examples of such materials include metal materials, a nonmetal inorganic materials, and resin materials.

Usually, when a metal material is used as the substrate 21, a short circuit is easily caused. However, with the present embodiment, it is possible to prevent the formation of a cathode layer 27 of which an end portion is spread outside the desired pattern. Thereby, the cathode layer 27 is prevented from being cut when, after organic EL devices 20 are formed over the substrate 21, the film formation patterns are cut so as to be separated from each other. Therefore, it is possible to prevent a short circuit which is caused when a burr, and the like, formed by cutting the cathode layer 27 is electrically connected to the substrate 21 formed of the metal material.

Examples of the metal materials include stainless steel, alloys such as iron-nickel alloy, copper, nickel, iron, aluminum, and titanium. Further, examples of the above-mentioned iron-nickel alloy include alloy 36 and alloy 42. Among these, the above-mentioned metal material is preferably stainless steel, copper, aluminum, or titanium, from the viewpoint of ease of application to the roll process. Further, from the viewpoint of handling and winding properties of the substrate, it is preferable that the thickness of the substrate formed of the metal material be 5 to 200 µm.

As the above-mentioned nonmetal inorganic materials, glass can be mentioned, for example. In this case, thin film glass to which flexibility is imparted can be used as a substrate formed of a nonmetal inorganic material. Further, from the viewpoint of sufficient mechanical strength and suitable plasticity, it is preferable that the thickness of the substrate formed of the non-metal material be 5 to 500 µm.

As the above-mentioned resin materials, synthetic resins such as thermosetting resins and thermoplastic resins can be mentioned. Examples of the synthetic resins include a polyimide resin, a polyester resin, an epoxy resin, a polyurethane resin, a polystyrene resin, a polyethylene resin, a polyamide resin, an acrylonitrile-butadiene-styrene (ABS) copolymer resin, a polycarbonate resin, a silicone resin, and a fluororesin. Further, as a substrate formed of such a resin material, films of those synthetic resins mentioned above can be used, for example. Further, from the viewpoint of sufficient mechanical strength and suitable plasticity, it is preferable that the thickness of the substrate formed of the resin material be 5 to 500 µm.

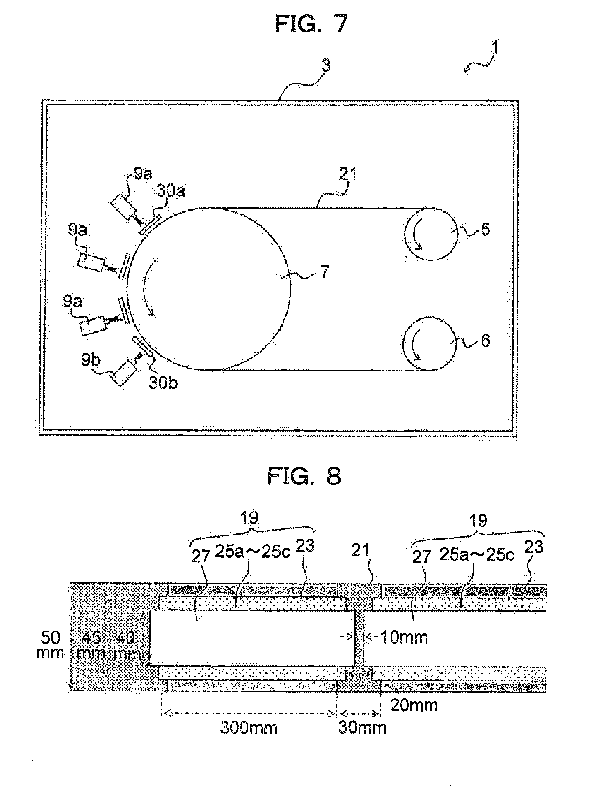

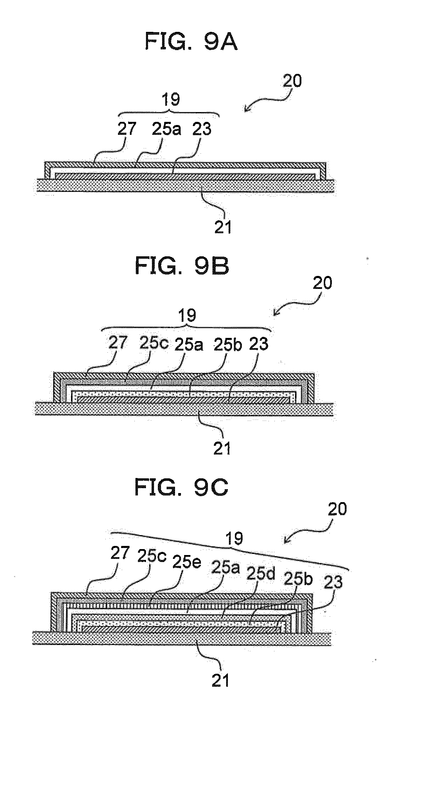

An anode layer 23 is formed beforehand by sputtering over the surface of the substrate 21 (see FIG.8 and FIG.9).

As the material for forming the anode layer 23, it is possible to use various transparent conductive materials such as indium-zinc oxide (IZO), and indium-tin oxide (ITO), a metal such as gold, silver, platinum, and aluminum, and an alloy material of such metal.

Further, it should be noted that, when a material, which can be deposited by an evaporation source, is used as the material of the anode layer 23, the anode layer 23 can also be formed by arranging the evaporation source of the anode layer 23 in the vacuum chamber 3, and depositing the anode layer 23 over the substrate 21 in a state where a shadow mask similar to the shadow masks 30a and 30b is arranged between the substrate 21 and the evaporation source of the anode layer 23. Examples of such deposition material can include gold, silver, aluminum, and the like.

The first and second evaporation sources 9a and 9b are used for forming the constituent layers of the organic EL film 19. In the present embodiment, the first evaporation source 9a is configured so as to form organic layers including a light emitting layer 25a (see FIG.8), and the second evaporation source 9b is configured so as to form the cathode layer 27. It should be noted that one or more of the first evaporation sources 9a are provided in correspondence with organic layers to be formed. In the present embodiment, the first evaporation source 9a is provided at one place so as to form the light emitting layer 25a as the organic layer (see FIG. 8 and FIG. 9A).

The organic layer is composed of one or more organic constituent layers. When the organic layer is composed of one organic constituent layer, the organic constituent layer is the light emitting layer 25a described above. When the organic layer is composed of a plurality of organic constituent layers, the organic constituent layers are composed of the light emitting layer 25a and the organic constituent layers other than the light emitting layer 25a. Further, examples of the organic constituent layers other than the light emitting layer 25a include a hole injection layer 25b, a hole transporting layer 25d, an electron injection layer 25c, an electron transporting layer 25e, and the like.

It should be noted that, for example, when the organic layer is formed as a three-layer laminated body as shown in FIG. 9B, it is possible to adopt a configuration in which the first evaporation sources 9a are provided at three places along the rotation direction of the can roll 7 as shown in FIG. 7. When the plurality of first evaporation sources 9a are provided along the rotation direction of the can roll 7 in this way, the organic layer can be formed as follows: after the first organic constituent layer is deposited over the anode layer 23 by the first evaporation source 9a arranged on the most upstream side in the rotation direction, the second and subsequent organic constituent layers are successively deposited and laminated over the first organic constituent layer by the first evaporation sources 9a arranged on the downstream side.

Further, as shown in FIG. 1, the first evaporation source 9a and the second evaporation source 9b are respectively arranged at positions facing the support region of the substrate 21 on the circumferential surface of the can roll 7, and are respectively located on the upstream and downstream sides in the conveying direction (moving direction) of the substrate 21. Each of the first and second evaporation sources 9a and 9b is configured to accommodate therein each of an organic layer forming material 22 and a cathode layer forming material 28, and includes each of nozzles 10a and 10b, and each of heating units (not shown).

Further, the nozzles 10a and 10b are respectively arranged at positions which face the supporting region of the can roll 7 supporting the substrate 21 and which are close to the substrate 21. That is, the nozzles 10a and 10b are respectively arranged at positions such that the distance (shortest distance) between the substrate 21 and the nozzles 10a and 10b is not more than 15 mm.

Each of the heating units of the first and second evaporation sources 9a and 9b is configured to heat and evaporate each of the organic layer forming material 22 and the cathode layer forming material 28 and is configured to discharge each of the vaporized organic layer forming material 22 and the vaporized cathode layer forming material 28 to the outside from each of the nozzles 10a and 10b. Each of the organic layer forming material 22 and the cathode layer forming material 28, which are respectively heated by the heating units and discharged from the nozzles 10a and 10b, is made to pass through each of the pattern-forming openings 31a and 31b of the later described shadow masks 30a and 30b and is thereby deposited over the substrate 21. It should be noted that the detail of the nozzles 10a and 10b is described below.

As shown in FIG.1 and FIG.2, each of the shadow masks 30a and 30b includes a rotating body having a plate shape in which each of the pattern-forming openings 31a and 31b is formed, and which is rotationally driven around each of the rotary shafts 32a and 32b. Here, the shadow mask 30a corresponding to the first evaporation source 9a has completely the same configuration as that of the shadow mask 30b corresponding to the second evaporation source 9b. Therefore, in the following, as shown in FIG.2 and FIG.3, the configuration of the shadow mask 30a corresponding to the first evaporation source 9a is described, and the description of the configuration of the shadow mask 30b corresponding to the second evaporation source 9b is not repeated.

In the present embodiment, the shadow mask 30a is formed to have a disc shape which is rotated around the rotary shaft 32a (that is, the center S of the rotary shaft 32a). Further, a plurality of the pattern-forming openings 31a, each of which is formed into an arc shape centering on the rotary shaft 32a, are formed in the shadow mask 30a along a virtual concentric circle R centering on the rotary shaft 32a.

When the pattern-forming opening 31a is formed to have the arc shape as described above, the pattern-forming opening 31a can be more easily made to pass through the desired position corresponding to the nozzle 10a only by rotating the shadow mask 30a around the single rotary shaft 32a, and hence an organic layer constituent layer can be more efficiently formed. Further, a plurality of the pattern-forming openings 31a are formed along the virtual concentric circle R as described above, and hence the degree of freedom of design of a film formation pattern can be increased. It should be noted that, in the present embodiment, three of the pattern-forming openings 31a are formed at equal intervals along the virtual concentric circle R described above.

Further, the rotary shaft 32a of the shadow mask 30a is mechanically connected to a second drive unit 43 provided with a motor or the like, and the rotational drive force generated by the second drive unit 43 is transmitted to the rotary shaft 32a, so as to rotate the shadow mask 30a. Further, the second drive unit 43 is electrically connected to the later described control unit 45, and the rotational speed of the shadow mask 30a is adjusted by the control unit 45 via the second drive unit 43 so as to adjust the moving speed of the pattern-forming opening 31a.

The shadow mask 30a is provided between the first evaporation source 9a and the substrate 21. Specifically, the shadow mask 30a is provided between the substrate in contact with the can roll 7, and the nozzle 10a of the first evaporation source 9a, so as to be close to the substrate 21. That is, the shadow mask 30a is arranged at a position such that the distance between the shadow mask 30a and the substrate 21 is not more than 1 mm.

Further, the shadow mask 30a is rotated as shown in FIG.2. Therefore, while the pattern-forming opening 31a overlaps with the opening of the nozzle 10a of the first evaporation source 9a, the vaporized material discharged from the nozzle 10a is deposited over the substrate 21. On the other hand, while the pattern-forming opening 31a does not overlap with the opening of the nozzle 10a, the vaporized material discharged from the nozzle 10a is attached to the region of the shadow mask 30a, in which region the pattern-forming opening 31a is not formed, and hence is not deposited over the substrate 21. That is, while the shadow mask 30a is rotated so as to follow the movement of the substrate 21, the vaporized organic layer forming material 22 is fed to the side of the substrate 21 through the opening 31a.

Further, it is configured such that the length L of the pattern-forming opening 31a in the radial direction D of the virtual concentric circle described above is less than the opening length of the nozzle 10a in the width direction of the substrate 21. The length L of the pattern-forming opening 31a can be suitably designed according to the pattern of an organic layer to be formed. Further, as the curvature of the pattern-forming opening 31a is increased, the size of the apparatus is reduced, but on the other hand, a rectangular pattern tends to become difficult to be formed. As the curvature of the pattern forming opening 31a is reduced, a rectangular pattern can be more easily formed, but on the other hand, the size of the apparatus may be increased. Therefore, the curvature can be suitably designed, for example, in consideration of these viewpoints.

Examples of the material for forming the shadow mask 30a include metal materials, nonmetal materials, and the like.

Examples of the metal material can include stainless steel, aluminum, titanium, and tungsten. Among these, from the viewpoint of heat resistance, rigidity and workability, it is preferable that the metal material be stainless steel. The thickness of the shadow mask 30a made of such metal material can be, for example, 0.01 mm to 2 mm.

Examples of the nonmetal material can include glass, and ceramic. The thickness of the shadow mask 30a made of such nonmetal material can be, for example, 0.01 mm to 2 mm.

Next, the relationship between the length of the opening of the nozzle 10a in the conveying direction of the substrate 21 and the size of the shadow mask 30a is described. As shown in FIG.4, when viewed along the direction perpendicular to the shadow mask 30a, the opening of the nozzle 10a is arranged along the radial direction D of the virtual concentric circle R (see FIG.2). Further, r, θ and W satisfy the expression: W = 2 × r × sin (θ / 2), where the distance between the center S of the rotary shaft 32a and each of contact points P, at which two virtual tangent lines M passing through the center S are in contact with the opening of the nozzle 10a, is r (mm), the angle formed by the two virtual tangent lines M is θ (°), and the opening length of the nozzle 10a in the conveying direction (vertical direction in FIG.4) of the substrate 21 is W (mm).

Here, it is preferable that the angle θ≤10°. Further, the above expression should be W = 2 × r × sin (10° / 2) = 0.174·r, where the angle θ = 10°. Therefore, when θ ≤ 10°, it is preferable that the opening length W be not more than 0.174·r mm. Further, it is preferable that r be not less than 10 mm but not more than 500.

In consideration of these, when the angle θ ≤ 10°, it is preferable that the opening length W of the nozzle 10a in the conveying direction of the substrate 21 be not less than 0.5 mm but not more than 0.174·r mm and be not less than 1 mm but not more than 10 mm. In the case where the length W is less than 0.5 mm, the discharging amount becomes small so that the film formation becomes difficult to be made. On the other hand, in the case where the length W is not less than 0.5 mm but not more than 0.174·r mm, opposite edges of the opening 31a of the shadow mask 30a in the substrate width direction (left-right direction in FIG.4) become close to parallel to the conveying direction of the substrate 21 at the time when the opening 31a of the shadow mask 30a overlaps with the opening of the nozzle 10a. Therefore, in this case, it is possible to prevent the formation of a pattern having a blurred outline at opposite edges thereof in the substrate width direction. Thereby, a rectangular pattern can be more easily formed.

Further, after the length W is set in this way, it is possible to design the size of the shadow mask 30a so that r and θ satisfy the above-described expression.

Further, the light emitting layer 25a (see FIG.8 and FIG.9) is formed over the anode layer 23 by discharging the vaporized organic layer forming material 22 from the first evaporation source 9a to pass through the pattern-forming opening 31a of the shadow mask 30a and thereby depositing the material on the anode layer 23 over the substrate 21. Further, the cathode layer 27 is formed over the light emitting layer 25a by discharging the vaporized cathode layer forming material 28 from the second evaporation source 9b to pass through the pattern-forming opening 31b of the shadow mask 30b and thereby depositing the material on the light emitting layer 25a.

In this way, the organic EL film 19 is formed over the substrate 21 by successively depositing the light emitting layer 25a and the cathode layer 27 on the anode layer 23 formed over the substrate 21. Thereby, the organic EL device 20 is formed.

The organic layer formed by the first deposition source 9a described above is not limited in particular as long as it includes the light emitting layer 25a. For example, as shown in FIG.9B, the organic layer can be formed to have three layers by laminating the hole injection layer 25b, the light emitting layer 25a, and the electron injection layer 25c in this order. Further, the organic layer can be formed, as required, to have four layers by sandwiching the hole transporting layer 25d (see FIG.9C) between the light emitting layer 25a and the hole injection layer 25b which are shown in FIG.9B or by sandwiching the electron transporting layer 25e (see FIG.9C) between the light emitting layer 25a and the electron injection layer 25c.

Further as shown in FIG.9C, the organic layer can be formed to have five layers by sandwiching the hole transporting layer 25d between the hole injection layer 25b and the light emitting layer 25a and by sandwiching the electron transporting layer 25e between the light emitting layer 25a and the electron injection layer 25c. Further, the thickness of each of the layers is usually designed to be several nm to several tens nm. However, the thickness is suitably designed according to the organic layer forming material 22, the light emitting characteristics, and the like, and hence is not limited in particular.

Examples of the material that can be used for forming the light emitting layer 25a include tris (8-hydroxyquinoline) aluminum (Alq3) and iridium complex (Ir(ppy)3)-doped 4,4'-N,N'-dicarbazolyl biphenyl (CBP).

Examples of the material that can be used for forming the hole injection layer 25b include copper phthalocyanine (CuPc), 4, 4' -bis [N-4- (N, N-di-m-tolylamino) phenyl)-N-phenylamino] biphenyl (DNTPD), and the like.

Examples of the material that can be used for forming the hole transporting layer 25d include 4,4'-bis[N-(1-naphthyl)-N-phenyl-amino]biphenyl (α-NPD) and N,N'-diphenyl-N,N'-bis(3-methylphenyl)-1,1'biphenyl-4,4'diamine (TPD).

Examples of the material that can be used for forming the electron injection layer 25c include lithium fluoride (LiF), cesium fluoride (CsF), and lithium oxide (Li₂O).

Examples of the material that can be used for forming the electron transporting layer 25e include tris (8-hydroxyquinoline) aluminum (Alq3), bis(2-methyl-8-quinolinolato)-4-phenylphenolato-aluminum (BAlq), and OXD-7(1,3-bis[5-(p-tert-butylphenyl)-1,3,4-oxadiazole-2-yl])benzene.

Examples of the material that can be used for forming the cathode layer 27 include aluminum (Al), silver (Ag), ITO, an alkali metal, and an alloy containing an alkaline earth metal.

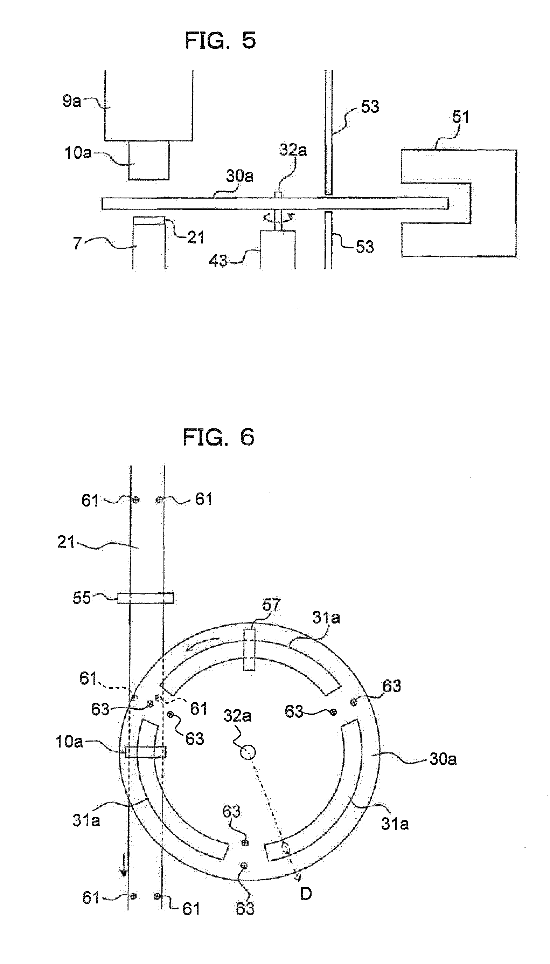

In the present embodiment, as shown in FIG.5, the manufacturing apparatus 1 further includes a removing unit 51 which can remove the organic layer forming material 22 and the cathode layer forming material 28 (constituent layer forming materials of the organic EL film 19) respectively attached to the shadow masks 30a and 30b while the organic layer including the light emitting layer 25a, and the cathode layer 27 (constituent layers of the organic EL film 19) are being formed over the substrate 21. Further, a partition plate 53 for separating each of the removing units 51 from each of the first evaporation source 9a and the second evaporation source 9b is arranged in the vacuum chamber 3. When the organic layer forming material 22 and the cathode layer forming material 28 are respectively removed by the removing units 51, the scattering of these materials can be prevented by the partition plate 53 arranged in this way. It should be noted that the removing units 51 for respectively removing the constituent layer forming materials attached to the shadow masks 30a and 30b have the same configuration, and hence the illustration of the removing unit 51 for the shadow mask 30b is not repeated.

In this way, during the time when the constituent layers of the organic EL film 19 are formed over the substrate 21, the constituent materials of the organic EL film 19 respectively attached to the shadow masks 30a and 30b are removed. Thereby, it is possible to prevent the occurrence of adverse effects on the deposition of the constituent layers of the organic EL film 19 due to the constituent layer forming materials of the organic EL film 19 which are respectively attached to the shadow masks 30a and 30b.

Further, the removing unit 51 is not limited in particular, but is preferably a device configured to remove, by dry etching or heating, the constituent materials of the organic EL film 19 which are respectively attached to the shadow masks 30a and 30b. Thereby, it is possible to efficiently avoid such a problem that the substrate 21 and the formed constituent layers are contaminated as estimated in mass production.

Further, in the present embodiment, as shown in FIG.6, the manufacturing apparatus 1 further includes a first detection unit 55 for detecting the moving speed of the substrate 21, and a second detection unit 57 for detecting the rotation speed of each of the shadow masks 30a and 30b (that is, the rotation speed of each of the pattern-forming openings 31a and 31b). The first detection unit 55 and the second detection unit 57 are electrically connected to the control unit 45. Further, as described above, the control unit 45 is electrically connected to the first drive unit 41 and the second drive unit 43. The control unit 45 is configured such that, on the basis of the detection results of the first detection unit 55 and the second detection unit 57, the control unit 45 can adjust the rotation of the shadow masks 30a and 30b so as to make the rotation of the shadow masks 30a and 30b follow the movement of the substrate 21.

It should be noted that the rotation adjustment performed for the shadow mask 30a by using the first detection unit 55, the second detection unit 57, and the control unit 45 is the same as the rotation adjustment performed for the shadow mask 30b. Therefore, in the following, only the rotation adjustment performed for the shadow mask 30a is specifically described, and the description of the rotation adjustment performed for the shadow mask 30b is not repeated.

It is configured such that the moving speed of the substrate 21 is detected by the first detection unit 55 when the first detection unit 55 detects first alignment marks 61 provided on the body of the substrate 21. Further, it is configured such that the rotation speed of the shadow mask 30a is detected by the second detection unit 57 when the second detection unit 57 detects second alignment marks 63 provided on the body of the shadow mask 30a.

Further, the adjustment of rotation of the shadow mask 30a is performed by the control unit 45, which calculates a deviation between the timing at which the first alignment marks 61 is detected by the first detection unit 55 and the timing at which the second alignment marks 63 are detected by the second detection unit 57, as the amount of deviation between the moving speed of the substrate 21 and the rotation speed of the shadow mask 30a and, on the basis of the calculation result, the control unit 45 adjusts the rotation speed of the shadow mask 30a so that the first alignment mark 61 and the second alignment mark 63 overlap each other in the region facing the nozzle 10a of the first evaporation source 9a.

In this way, when the rotation of the shadow mask 30a is adjusted so as to make the rotation of the shadow mask 30a follow the movement of the substrate 21, it is possible, for example, to more surely form a pattern of the subsequent constituent layer (for example, the light emitting layer 25a) in correspondence with the movement of the pattern of the constituent layer (for example, the anode layer 23) formed previously over the substrate 21. Thereby, even when the interval between patterns of constituent layers to be successively formed is not fixed, the subsequent constituent layer can be more surely formed at a suitable position on the previously formed constituent layer. Therefore, it is possible to increase the degree of freedom in the formation of the organic EL film 19.

It should be noted that the shape, size, arrangement, and the like, of the first alignment mark 61 and the second alignment mark 63 are not limited in particular as long as the first alignment mark 61 and the second alignment mark 63 can be respectively detected by the first detection unit 55 and the second detection unit 57. Further, the end portion of the pattern-forming openings 31a and 31b may be used as the alignment marks.

A manufacturing method of an organic EL device according to the present embodiment includes: feeding the substrate 21 having a strip shape to the can roll (conveyance unit) 7; conveying the substrate 21 while one surface side of the substrate 21 is in contact with the surface of the can roll 7; arranging the shadow masks 30a and 30b, respectively provided with rotating bodies each having a plate shape that are respectively rotationally driven around the rotary shafts 32a and 32b and have the pattern-forming openings (openings) 31a and 31b respectively formed therein, in the vicinity of the substrate 21 in contact with the can roll 7, and between the substrate 21 and the respective nozzles 10a and 10b of the first and second evaporation sources 9a and 9b arranged opposite to the can roll 7 and close to the substrate 21; and while the shadow masks 30a and 30b are being rotated so as to follow the movement of the substrate 21, discharging the vaporized organic layer forming material 22 and the vaporized cathode layer forming material 28 (constituent layer forming materials of the organic EL film) respectively from the nozzles 10a and 10b to feed the vaporized organic layer forming material 22 and the vaporized cathode layer forming material 28 to the substrate 21 side respectively through the openings 31a and 31b to form the light emitting layer 25a and the cathode layer 27 (constituent layers of the organic EL film) on the other surface side of the substrate 21 to the can roll 7.

Specifically, in the present embodiment, the anode layer 23 is first formed beforehand on the one surface side of the substrate 21, for example, by sputtering, or the like, and then the substrate 21 wound into a roll is unwound from the substrate feeding roll 5.

Then, in a state where, while the substrate 21 is being moved while one surface side of the substrate 21 is in contact with the surface of the can roll 7, the shadow masks 30a and 30b are rotated so as to follow the movement of the substrate 21, the organic layer forming material 22 discharged from the first evaporation source 9a is made to pass through the pattern-forming opening 31a to thereby form the light emitting layer 25a on the anode layer 23 formed over the substrate 21 supported by the can roll 7, and the cathode layer forming material 28 discharged from the second evaporation source 9b is made to pass through the pattern-forming opening 31b to thereby form the cathode layer 27 on the light emitting layer 25a. Thereby, the organic EL film 19 is formed over the substrate 21. Further, while the organic EL film 19 is being formed over the substrate 21, the substrate 21 with the organic EL film 19 formed thereon is wound by the substrate take-up unit 6.

Since, with the manufacturing method described above, the shadow masks 30a and 30b are respectively supported by the rotary shafts 32a and 32b, it is possible to prevent the occurrence of a variation in the distance between the substrate 21 and each of the shadow masks 30a and 30b, and to prevent a deviation from being caused in the follow-up movement of each of the shadow masks 30a and 30b with respect to the movement of the substrate 21. Further, since the shadow masks 30a and 30b are arranged close to the substrate 21, it is possible to prevent the end portion of each of the light emitting layer 25a and the cathode layer 27 from being extended to the outside of the desired pattern. Therefore, it is possible to manufacture an organic EL device 20 in which the deterioration of the quality is suppressed.

As described above, the manufacturing method of the organic EL device according to the present embodiment includes: feeding the substrate 21 having a strip shape to the conveyance unit 7; conveying the substrate 21 while one surface side of the substrate 21 is in contact with the surface of the conveyance unit 7; arranging the shadow masks 30a and 30b, respectively provided with rotating bodies each having a plate shape that are respectively rotationally driven around the rotary shafts 32a and 32b and have the openings 31a and 31b respectively formed therein, in the vicinity of the substrate 21 in contact with the conveyance unit 7, and between the substrate 21 and the respective nozzles 10a and 10b of the evaporation sources 9a and 9b arranged opposite to the conveyance unit 7 and close to the substrate 21; and while the shadow masks 30a and 30b are being rotated so as to follow the movement of the substrate 21, discharging the vaporized constituent layer forming materials 22 and 28 respectively from the nozzles 10a and 10b to feed the vaporized constituent layer forming materials 22 and 28 to the substrate 21 side through the openings 31a and 31b to form the constituent layers of the organic EL film 19 on the other surface side of the substrate 21 to the conveyance unit 7.

Since, with the above-described configuration, the shadow masks 30a and 30b are respectively supported by the rotary shafts 32a and 32b, it is possible to prevent the occurrence of a variation in the distance between the substrate 21 and each of the shadow masks 30a and 30b, and to prevent a deviation from being caused in the follow-up movement of each of the shadow masks 30a and 30b with respect to the movement of the substrate 21. Further, since the shadow masks 30a and 30b are arranged close to the substrate 21, it is possible to prevent the end portion of each of the light emitting layer 25a and the cathode layer 27 (constituent layers of the organic EL film) from being extended to the outside of the desired pattern. Therefore, it is possible to manufacture the organic EL device 20 of a relatively excellent quality.

Further, in the manufacturing method of the organic EL device according to the present embodiment, it is preferable that the constituent layer of the organic EL film 19 is composed of one or more of the organic layer including the light emitting layer 25a, the anode layer 23, and the cathode layers 27.

When the constituent layer of the organic EL film 19 is the organic layer, it is possible to prevent the end portion of the organic layer in the conveying direction of the substrate 21 from extending to the outside of the desired pattern. Thereby, when the film formation patterns are cut and separated from each other after the organic layer has been formed over the substrate 21, it is possible to prevent the organic layer from being cut so as to adversely affect the life of the organic layer. Further, when the constituent layer is the anode layer 23 or the cathode layer 27, it is possible to prevent the end portion of the anode layer 23 or the cathode layer 27 from extending to the outside of the desired pattern. Thereby, when the film formation patterns are cut and separated from each other after the anode layer 23 or the cathode layer 27 has been formed over the substrate 21, it is possible to prevent the anode layer 23 or the cathode layer 27 from being cut so as to cause a short-circuit. Further, when the organic layer, the anode layer 23, and the cathode layer 27 are formed by deposition as described above, it is not necessary to use a complicated process such as, for example, a photolithography process, in order to form these layers, and hence it is possible to prevent an increase in the cost.

Further, in the manufacturing method of the organic EL device according to the present embodiment, it is possible that the constituent layer of the organic EL film 19 is the cathode layer 27, and the substrate 21 is formed of a metal material.

Usually, when such substrate 21 is used, a short-circuit is easily caused. However, with the present embodiment, it is possible to prevent the end portion of the cathode layer 27 from extending to the outside of the desired pattern. Thereby, when the film formation patterns are cut and separated from each other after the organic EL device 20 has been formed over the substrate 21, it is possible to prevent the cathode layer 27 from being cut. Therefore, it is possible to prevent a burr, and the like, formed by cutting the cathode layer 27 from being electrically connected to the substrate 21 formed of the metal material, so as to cause a short circuit.

Further, in the manufacturing method of the organic EL device according to the present embodiment, it is preferable that the conveyance unit 7 be a can roll rotationally driven around the rotary shaft 7a.

Thereby, since the conveyance unit 7 is supported by the one rotary shaft 7a, the substrate 21 can be stably conveyed by the conveyance unit 7, and hence it is possible to further suppress a change in the distance between the substrate 21 and each of the shadow masks 30a and 30b.

Further, in the manufacturing method of the organic EL device according to the present embodiment, it is preferable that the shadow masks 30a and 30b are configured to be rotated respectively around the rotary shafts 32a and 32b perpendicular to the rotary shaft 7a of the conveyance unit 7.

Thereby, it is possible to more securely prevent the occurrence of a variation in the distance between the substrate 21 and each of the shadow masks 30a and 30b, and to more securely prevent a deviation from being caused in the follow-up movement of each of the shadow masks 30a and 30b with respect to the movement of the substrate 21.

Further, in the manufacturing method of the organic EL device according to the present embodiment, it is preferable that, during the time when the constituent layers of the organic EL film 19 are formed over the substrate 21, the constituent layer forming materials of the organic EL film 19, which are respectively attached to the shadow masks 30a and 30b, are removed.

Thereby, it is possible to prevent the constituent layer forming materials of the organic EL film 19, which are attached to the shadow masks 30a and 30b, from adversely affecting the deposition of the constituent layers of the organic EL film 19. Further, when the in-line washing is performed in this way, the deposition can be constantly performed by using a fresh shadow mask, and hence it is possible to easily form a good film formation pattern.

Further, in the manufacturing method of the organic EL device according to the present embodiment, it is preferable that the constituent layer forming materials of the organic EL film 19, which are respectively attached to the shadow masks 30a and 30b, are removed by dry etching or heating.

In the case where the attached constituent layer forming material is removed by dry etching or heating, the attached constituent layer forming material can be removed in vacuum. Further, when the attached constituent layer forming material is removed in vacuum, it is possible to prevent the entry of foreign matter from the outside, and hence the attached constituent layer forming material can be removed more effectively.

Further, in the manufacturing method of the organic EL device according to the present embodiment, it is preferable that each of the openings 31a and 31b be formed in an arc shape centering on each of the rotary shafts 32a and 32b of the shadow masks 30a and 30b, and that a plurality of the openings be arranged along the virtual concentric circle R centering on each of the rotary shafts 32a and 32b of the shadow masks 30a and 30b.

In this way, when each of the openings 31a and 31b is formed in an arc shape, and when a plurality of the openings are arranged along the virtual concentric circle R, the openings 31a and 31b can be made more easily to pass respectively through the desired positions with respect to the nozzles 10a and 10b only by rotating the shadow masks 30a and 30 respectively around the rotary shafts 32a and 32b. Thereby, it is possible to form the constituent layers of the organic EL film 19 more efficiently. Further, a plurality of each of the openings 31a and 31b are formed along the virtual concentric circle R, and hence it is possible to enhance the degree of freedom in design of the film formation pattern.

Further, in the manufacturing method of the organic EL device according to the present embodiment, it is preferable that, when viewed along the direction perpendicular to the shadow masks 30a and 30b, each of the openings of the nozzles 10a and 10b is arranged along the radial direction D of the virtual concentric circle R, and that, r, θ and W satisfy the expression: W = 2 × r ×θ sin (θ / 2), where the distance between the center S of each of the rotary shafts 32a and 32b, and each of contact points P, at which two virtual tangent lines M passing through the center S are in contact with the opening of each of the nozzles 10a and 10b, is r (mm), the angle formed by the two virtual tangent lines M is θ (°), and the opening length of each of the nozzles 10a and 10b in the conveying direction of the substrate 21 is W (mm).

In this way, when r, θ and W satisfy the above-described expression, it is possible to more suitably design the length of the openings of the nozzles 10a and 10b, and the size of the shadow masks 30a and 30b.

Further, in the manufacturing method of the organic EL device according to the present embodiment, it is preferable that the opening length W of the nozzles 10a and 10b in the conveying direction of the substrate 21 is not less than 0.5 mm but not more than 0.174·r mm or less, where the angle θ ≤ 10°.

Thereby, when each of the openings 31a and 31b of the shadow masks 30a and 30b overlaps with each of the openings of the nozzle 10a and 10b, opposite edges of each of the opening 31a and 31b of the shadow masks 30a and 30b in the width direction of the substrate 21 become close to parallel to the conveying direction of the substrate 21, and hence it is possible to prevent the formation of a pattern having a blurred outline of the opposite edges in the width direction of the substrate 21.

The manufacturing apparatus 1 of the organic EL device, according to the present embodiment, includes: the substrate feeding unit 5 configured to feed the substrate 21 having a strip shape; the conveyance unit 7 configured to convey the substrate 21 while one surface side of the substrate 21 is in contact with the surface of the conveyance unit 7; the evaporation sources 9a and 9b respectively provided with the nozzles 10a and 10b arranged opposite to the conveyance unit 7 and close to the substrate 21, the evaporation sources 9a and 9b being configured to discharge vaporized constituent layer forming materials of an organic EL film respectively from the nozzles 10a and 10b so as to form constituent layers of the organic EL film on the surface side of the substrate 21, the surface side being opposite to the conveyance unit 7; and the shadow masks 30a and 30b respectively provided with rotating bodies each having a plate shape that are respectively rotationally driven around the rotary shafts 32a and 32b and have the openings 31a and 31b respectively formed therein, the shadow masks 30a and 30b being arranged in the vicinity of the substrate 21 in contact with the conveyance unit 7, and between the substrate 21 and the respective nozzles 10a and 10b, and is configured such that the shadow masks 30a and 30b are rotated so as to follow the movement of the substrate 21 and thereby the vaporized constituent layer forming materials are respectively fed through the openings 31a and 31b to the substrate 21 side.

The method and apparatus for manufacturing the organic EL device, according to the present invention, are configured as described above. However, the present invention is not limited to the above-described embodiment, and suitable design modifications are possible within the scope intended by the present invention. For example, the shape and size of the shadow masks 30a and 30b, the shape and size of the pattern-forming openings 31a and 31b, and the like, which are shown in the above-described embodiment, are not limited in particular.

Further, in the above-described embodiment, a configuration is shown in which the conveyance unit is the can roll 7, but the conveyance unit is not limited in particular to the can roll 7. Other than the can roll 7, the conveyance unit can also be configured as a belt conveyor. Further, in the above-described embodiment, the substrate feeding unit 5 is arranged in the vacuum chamber 3. However, as long as the substrate 21 is unwound to the can roll 7, the method for feeding the substrate 21 to the can roll 7 is not limited in particular. Further, in the above-described embodiment, the substrate 21 subjected to the deposition process is wound up, but can also be fed to a cutting process, or the like, without being wound up. Further, the operation effects of the method and apparatus for manufacturing of the organic EL device, according to the present invention, are not limited to the operation effects described above.

### Examples

In the following, the present invention is described in more detail by means of examples, but the present invention is not limited to the examples.

### (Example 1)

A manufacturing apparatus similar to the manufacturing apparatus 1 as shown in FIG.4 and FIG.7 was used. Further, in Example 1, the adjustment of rotation of the shadow mask using the alignment mark, the detection unit, and the control unit as described above was not performed. Three organic layer evaporation sources for forming an organic layer which was a three-layer laminated body, and a cathode layer evaporation source for forming a cathode layer were arranged in the vacuum chamber of the manufacturing apparatus so that the distance between the substrate and the nozzle of each of the evaporation sources was 2 mm. As the organic layer evaporation sources, a CuPb layer (hole injection layer) evaporation source, an α-NPD layer (light emitting layer) evaporation source, and an Alq3 layer (electron injection layer) evaporation source were arranged in this order from the upstream side to the downstream side in the conveying direction of the substrate.

Further, each of three shadow masks respectively used for the organic layers was arranged between the substrate and each of the organic layer evaporation sources, and a shadow mask used for the cathode layer was arranged between the substrate and the cathode layer evaporation source. The distance between the substrate and each of the shadow masks was 0.1 mm.

As the organic layer shadow mask, there was used a shadow mask configured to have a disk shape formed around a rotary shaft, and to have three pattern-forming openings, each having the above-described arc shape centering on the rotary shaft, and each having a rotation-direction length of 300 mm and a radial-direction length of 45 mm, the three pattern-forming openings being arranged at 20 mm intervals along the virtual concentric circle centering on the rotary shaft. Further, as the cathode layer shadow mask, there was used a shadow mask configured to have a disk shape formed around a rotary shaft, and to have three pattern-forming openings, each having the above-described arc shape centering on the rotary shaft, and each having a rotation-direction length of 300 mm and a radial-direction length of 40 mm, the three pattern-forming openings being arranged at 10 mm intervals along the virtual concentric circle centering on the rotary shaft.

Then, the inside of the vacuum chamber was evacuated to the degree of vacuum of 1×10⁻⁴ Pa, and thereafter the substrate with the anode layer formed thereon was unwound and conveyed to the can roll, during of which each of the shadow masks was rotated so as to follow the movement of the substrate on the can roll surface. Thereby, on the anode layer formed over the substrate, a rectangular organic layer pattern having a substrate conveying-direction length of 300 mm, and a substrate width-direction length of 45 mm was formed at intervals of 20 mm by each of the organic layer evaporation sources. Further, on the organic layer pattern, a rectangular cathode layer pattern having a substrate conveying-direction length of 300 mm, and a substrate width-direction length of 40 mm was formed at intervals of 10 mm by the cathode layer evaporation source. It should be noted that the conveying speed of the substrate was 0.96 m/s and the rotation speed of the shadow mask was 60 rpm.

The patterns of the anode layer, the organic layer, and the cathode layer in the obtained organic EL devices are shown in FIG.8. A voltage was applied between the anode layer and the cathode layer of the obtained organic EL devices without the organic EL devices being cut and separated from each other. As a result, in each of the organic EL devices, emission of green light was recognized in the region having the substrate conveying-direction length of 300 mm × the substrate width-direction length of 40 mm. Further, the light emission state in the region was uniform. Further, when organic EL devices were cut and separated from each other by cutting with a scissors, the obtained organic EL layer along the substrate width-direction and at the central portion between the organic EL films adjacent to each other in the longitudinal direction of the substrate, the occurrence of a fault, such as a short-circuit, was not recognized.

### (Example 2)

By using the manufacturing apparatus used in Example 1, organic EL devices were manufactured similarly to Example 1 except that the alignment marks the same as those shown in FIG.6 were provided at the body of the substrate and the body of each of the shadow masks similarly to the above-described embodiment, so that the moving speed of the substrate, and the rotation speed of the shadow mask were detected by the detection units, and that the deposition was performed while the rotation of each of the shadow masks was being adjusted by the control unit so as to follow the movement of the substrate with the moving speed of 3 m/s.

Then, similarly to Example 1, a voltage was applied between the anode layer and the cathode layer without the obtained organic EL devices being cut and separated from each other. As a result, also as for the respective organic EL devices, green light emission was recognized in the region having the substrate conveying-direction length 300 mm × the substrate width-direction length of 40 mm. Further, the light emission state in the region was uniform.

Further, when the obtained organic EL devices were cut and separated from each other similarly to Example 1, the occurrence of a fault, such as a short-circuit, was not recognized.

### (Comparative Example 1)

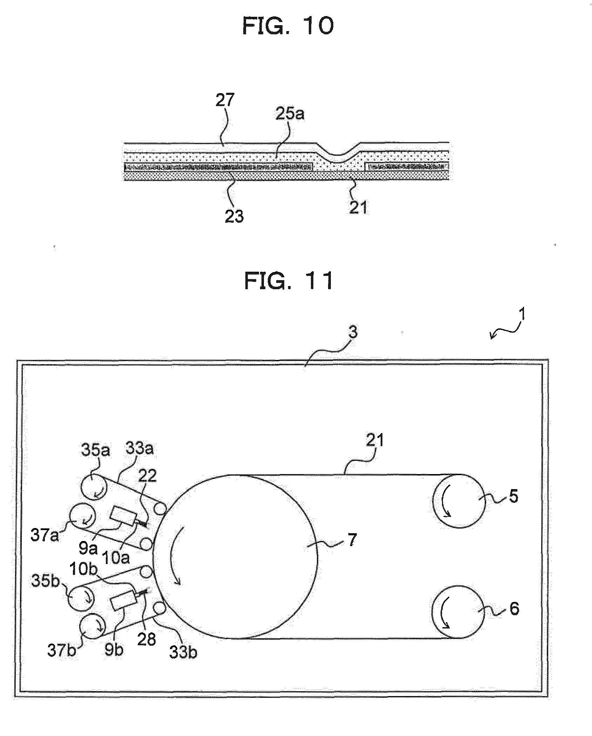

When organic EL devices were manufactured similarly to Example 1 except that a SUS material with an insulating layer formed on the surface thereof by coating JEM-433 (made by JSR Corporation) to a thickness of 3 mm was used as the substrate, and that the distance between the shadow mask and the substrate was 10 mm, organic EL devices as shown in FIG.10 were obtained. As a result, as shown in FIG.10, the end portion of the pattern of each of the organic layer and the cathode layer was extended to the outside of the desired pattern, so that the organic layers adjacent to each other were connected to each other, and also the cathode layers adjacent to each other were connected to each other.

Similarly to Example 1, a voltage was applied between the anode layer and the cathode layer without the organic EL devices being cut and separated from each other. As a result, in each of the organic EL devices, emission of green light was recognized in the region having the substrate conveying-direction length of 300 mm × the substrate width-direction length of 40 mm, but the light emission state in the region was not uniform because the thickness of the longitudinal ends of each of the organic EL films was small.

Further, when the organic EL devices were cut and separated from each other similarly to Example 1, in a part of the organic EL devices, a short-circuit was caused between the substrate and the cathode layer, and light emission was not recognized.

### (Comparative Example 2)

Organic EL devices were manufactured similarly to Comparative Example 1 except that the organic layer shadow mask and the cathode layer shadow mask were fixed without being rotated.

Similarly to Example 1, a voltage was applied between the anode layer and the cathode layer without the organic EL devices being cut and separated from each other. As a result, in each of the organic EL devices, emission of green light was recognized in the region having the substrate conveying-direction length of 300 mm × the substrate width-direction length of 40 mm.

However, when the organic EL devices were cut and separated from each other similarly to Example 1, in a part of the organic EL devices, a short-circuit was caused between the substrate and the cathode layer, and the number of the organic EL devices in which light emission was not recognized was larger than that in Comparative Example 1.

### (Comparative Example 3)

As shown in FIG.11, organic EL devices were manufactured similarly to Example 1 except that the deposition was performed by using a strip-shaped shadow mask instead of the rotary-type shadow mask as described above. In FIG.11, portions common to those in FIG.1 are denoted by the same reference numerals and characters, and the description thereof is omitted. As shown in FIG.11, strip-shaped shadow masks 33a and 33b are respectively hung over shadow mask unwinding rollers 35a and 35b. Each of the strip-shaped shadow masks 33a and 33b unwound from the shadow mask unwinding rollers 35a and 35b was fed between the can roll 7 and each of the nozzles 10a and 10b of the evaporation sources 9a and 9b, and then was wound by each of shadow mask winding rollers 37a and 37b. Also, the openings having the same size and pitch as those in Example 1 were formed in the strip-shaped shadow masks 33a and 33b. Further, the distance between the substrate 21 and each of the unwound strip-shaped shadow masks 33a and 33b was 0.1 mm.

Then, when, by using the manufacturing apparatus having the shadow masks having a strip shape described above, the light emitting layer and the cathode layer were formed, similarly to Example 1, on the anode layer formed over the substrate, the shadow mask and the anode layer formed over the substrate were rubbed with each other, so that the anode layer was damaged. Further, in the middle of the continuous film formation, a positional deviation was caused between the opening of the shadow mask having a strip shape, and the anode layer. Therefore, after the occurrence of the positional deviation, it was impossible to form an organic EL device satisfying the desired quality.

From the above results, it was found that the manufacturing method and apparatus for manufacturing the organic EL device, according to the present invention, can manufacture the organic EL device having a relatively excellent quality.

In the above, the embodiment and examples according to the present invention have been described, but it is also intended from the beginning to suitably combine features of each of the embodiment and examples. Further, it is to be understood that the embodiment and examples as described above are to be regarded as illustrative in all aspects, and not as restrictive. The scope of the present invention is indicated not by the embodiment and examples as described above but by the appended claims, and is intended to include all changes and modifications within the meaning and range of equivalents of the appended claims.

### REFERENCE SIGNS LIST

- 1:: Manufacturing apparatus of organic EL device
- 3:: Vacuum chamber
- 5:: Substrate feeding unit
- 7:: Can roll (conveyance unit)
- 9:: Evaporation source
- 21:: Substrate
- 23:: Anode layer (electrode layer)
- 25a:: Light emitting layer (organic constituent layer, organic layer)
- 27:: Cathode layer (electrode layer)
- 30a, 30b:: Shadow mask
- 31a (31b):: Pattern-forming opening (opening)
- 32a (32b):: Rotary shaft
- 41:: First drive unit
- 43:: Second drive unit
- 45:: Control unit
- 51:: Removing unit
- 53:: Partition plate
- 55:: First detection unit
- 57:: Second detection unit
- 61:: First alignment mark
- 63:: Second alignment mark

## Claims

1. A manufacturing method of an organic EL device, comprising:
feeding a substrate having a strip shape to a conveyance unit;
conveying the substrate while one surface side of the substrate is in contact with a surface of the conveyance unit;
arranging a shadow mask, which has a rotating body having a plate shape rotationally driven around a rotary shaft and has an opening formed in the rotating body, in the vicinity of the substrate in contact with the conveyance unit, and between the substrate and a nozzle of an evaporation source arranged opposite to the conveyance unit and at a close position to the substrate;
while the shadow mask is being rotated so as to follow a movement of the substrate, discharging a vaporized constituent layer forming material of an organic EL film from the nozzle to feed the vaporized constituent layer forming material to the substrate side through the opening to form a constituent layer of the organic EL film on the other surface side of the substrate to the conveyance unit.

2. The manufacturing method of the organic EL device according to claim 1, wherein the constituent layer of the organic EL film is composed of one or more of an organic layer including a light emitting layer, an anode layer, and a cathode layer.

3. The manufacturing method of the organic EL device according to claim 2, wherein the constituent layer of the organic EL film is the cathode layer, and the substrate is formed of a metal material.

4. The manufacturing method of the organic EL device according to claim 1, wherein the conveyance unit is a can roll rotationally driven around the rotary shaft.

5. The manufacturing method of the organic EL device according to claim 4, wherein the shadow mask is configured to be rotated around the rotary shaft arranged perpendicular to a rotary shaft of the conveyance unit.

6. The manufacturing method of the organic EL device according to claim 1, further comprising removing the constituent layer forming material of the organic EL film attached to the shadow mask, while forming the constituent layer of the organic EL film over the substrate.

7. The manufacturing method of the organic EL device according to claim 6, wherein the constituent layer forming material of the organic EL film attached to the shadow mask is removed by dry etching or heating.

8. The manufacturing method of the organic EL device according to claim 1, wherein the opening is formed in an arc shape centering on the rotary shaft of the shadow mask, and a plurality of the openings are arranged along a virtual concentric circle centering on the rotary shaft of the shadow mask.

9. The manufacturing method of the organic EL device according to claim 8, wherein
when viewed along the direction perpendicular to the shadow mask, the opening of the nozzle is arranged along the radial direction of the virtual concentric circle, and
r, θ and W satisfy the expression: W = 2 × r × sin (θ / 2), where the distance between the center of the rotary shaft and each of contact points, at which two virtual tangent lines passing through the center of the rotary shaft are in contact with the opening of the nozzle, is r (mm), the angle formed by the two virtual tangent lines is θ (°), and the opening length of the nozzle in the conveying direction of the substrate is W (mm).

10. The manufacturing method of the organic EL device according to claim 9, wherein the opening length W of the nozzle in the conveying direction of the substrate is not less than 0.5 mm but not more than 0.174·r mm, where the angle θ ≤ 10°.

11. A manufacturing apparatus of an organic EL device, comprising:
a substrate feeding section configured to feed a substrate having a strip shape;
a conveyance section configured to convey the substrate while one surface side of the substrate is in contact with a surface of the conveyance section;
an evaporation source provided with a nozzle arranged opposite to the conveyance section and close to the substrate, the evaporation source being configured to discharge a vaporized constituent layer forming material of an organic EL film from the nozzle so as to form a constituent layer of the organic EL film on the other surface side of the substrate to the conveyance section; and
a shadow mask having a rotating body having a plate shape rotationally driven around a rotary shaft and having an opening formed in the rotating body, the shadow mask being arranged in the vicinity of the substrate in contact with the conveyance section, and between the nozzle and the substrate,
wherein the shadow mask is rotated so as to follow a movement of the substrate and thereby the vaporized constituent layer forming material is fed to the substrate side through the opening.
